(19) **Europäisches Patentamt**
**European Patent Office**
**Office européen des brevets**

(11) **EP 2 862 210 B1**

(12) **FASCICULE DE BREVET EUROPEEN**

(45) Date de publication et mention
de la délivrance du brevet:
**10.08.2016 Bulletin 2016/32**

(51) Int Cl.:
*H01L 41/09* *(2006.01)*    *H02N 2/10* *(2006.01)*
*H02N 2/00* *(2006.01)*

(21) Numéro de dépôt: **13728220.8**

(22) Date de dépôt: **13.06.2013**

(86) Numéro de dépôt international:
**PCT/EP2013/062266**

(87) Numéro de publication internationale:
**WO 2013/186308 (19.12.2013 Gazette 2013/51)**

(54) **MOTEUR ULTRASONIQUE**

ULTRASCHALLMOTOR

ULTRASONIC MOTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.06.2012 FR 1255649**

(43) Date de publication de la demande:
**22.04.2015 Bulletin 2015/17**

(73) Titulaire: **Commissariat à l'Énergie Atomique et aux Énergies Alternatives 75015 Paris (FR)**

(72) Inventeurs:
• **LEROY, Edouard**
**75013 Paris (FR)**
• **HAFEZ, Moustapha**
**F-94110 Arcueil (FR)**
• **LOZADA, José**
**Calle Madrid, SI N Y Via a Lumbisi (EC)**

(74) Mandataire: **Brevalex**
**95, rue d'Amsterdam**
**75378 Paris Cedex 8 (FR)**

(56) Documents cités:
**DE-A1-102009 039 922    US-A1- 2009 256 445**

• **LI ET AL: "Design and optimization of a novel annular sector curvilinear ultrasonic motor", ULTRASONICS SYMPOSIUM 2008, 2 novembre 2008 (2008-11-02), pages 1831-1834, XP031443220, ISBN: 978-1-4244-2428-3**
• **LI ET AL: "Particle swarm optimization combined with finite element method for design of ultrasonic motors", SENSORS AND ACTUATORS A, vol. 148, no. 1, 4 novembre 2008 (2008-11-04), pages 285-289, XP025535293, ISSN: 0924-4247, DOI: 10.1016/J.SNA.2008.08.004 [extrait le 2008-08-19]**

**Description**

DOMAINE TECHNIQUE ET ART ANTÉRIEUR

La présente invention se rapporte à un actionneur pour moteur ultrasonique et à un moteur ultrasonique comportant au moins un tel actionneur.

Les actionneurs ultrasoniques sont des actionneurs à un ou plusieurs degrés de liberté utilisés dans de nombreux domaines. Ils offrent une masse réduite et une grande compacité.

Les moteurs ultrasoniques mettent en oeuvre des actionneurs en matériau piézoélectrique disposés dans le stator qui, lorsqu'une tension alternative leur est appliquée, se mettent à vibrer. La forme des actionneurs et le signal de tension alternative sont déterminés de sorte à générer un mouvement elliptique qui appliqué à un rotor cylindrique ou sphérique l'entraine en rotation autour d'un axe donné.

Le mouvement elliptique peut être obtenu en combinant un mode longitudinal et un mode de flexion.

Un moteur utilisant un tel mouvement est par exemple décrit dans le document M. Zhang, W. Guo, et L. Sun, « A multi-degree-of-freedom ultrasonic motor using in-plane déformation of planar piezoelectric Elements », Sensors and Actuators A: Physical, vol. 148, n°. 1, p. 193-200, nov. 2008. Le moteur comporte quatre actionneurs linéaires montés en parallèles, chacun formé par une plaque en matériau piézoélectrique recouvert de quatre électrodes sur une face et une électrode sur l'autre face. Les quatre plaques sont fixées sur un boîtier en forme de parallélépipède rectangle percé d'un orifice servant de logement au rotor formé par une sphère. La mise en vibration du logement du rotor provoque la rotation du rotor.

Cet actionneur présente un certain encombrement.

Li et al. divulguent un actionneur d'un matériau piézoélectrique formé sur une plaque en laiton: "Design and optimization of a novel annular sector curvilinear ultrasonic motor", ULTRASONICS SYMPOSIUM 2008, pages 1831-1834; et "Particle swarm optimization combined with finite element method for design of ultrasonic motors", SENSORS AND ACTUATORS A, vol. 148, no. 1, pages 285-289. Il existe également des moteurs ultrasoniques dans lesquels les actionneurs sont en contact avec le rotor par l'intermédiaire d'une pointe.

Or ce contact a pour effet de localiser les contraintes, ce qui peut réduire la durée de vie du moteur. Un tel moteur est par exemple décrit dans le document Sheng-Chih Shen et Juin-Cherng Huang, « Design and Fabrication of a High-Power Eyeball-Like Microactuator Using a Symmetric Piezoelectric Pusher Element », Microelectromechanical Systems, Journal of, vol. 19, n°. 6, p. 1470-1476, 2010.

EXPOSÉ DE L'INVENTION

C'est par conséquent un but de la présente invention d'offrir un moteur ultrasonique d'encombrement réduit et offrant une durée de vie augmentée.

Le but précédemment énoncé est atteint par un actionneur en matériau piézoélectrique muni d'une zone de contact incurvée destinée à venir en contact avec le rotor, l'actionneur comportant des électrodes pour stimuler le mode en flexion et le mode longitudinal de sorte à générer un mouvement elliptique et mettre en rotation le rotor.

Grâce à cette zone de contact incurvée formée par un arc de cercle dont le rayon correspond sensiblement au rayon du rotor, cet actionneur offre une grande surface de contact avec le rotor ce qui permet de mieux répartir la contrainte au sein de l'actionneur et donc de réduire le risque d'apparition d'amorces de fissures localisées pouvant conduire à un éclatement de l'actionneur ainsi qu'à l'usure de la surface de contact qui détériore les performances. En outre, grâce à cette forme, la fabrication du moteur est simplifiée car elle permet de compenser des éventuels jeux de mise en place du rotor sur l'actionneur dont le bord de contact forme un berceau, notamment dans le cas de moteurs de petites tailles. Au moins deux points de contact sont assurés. En outre, le berceau ainsi formé assure un guidage du rotor.

L'utilisation de mouvements elliptiques constructifs tout au long de l'actionneur améliore le rendement de l'actionneur en augmentant la part utile de l'énergie électrique envoyée à l'actionneur. Ainsi, plusieurs points de contact effectuant des mouvements elliptique dans le même sens peuvent chacun transmettre une partie d'énergie mécanique, il en résulte une énergie mécanique transmise plus grande que dans le cas d'un unique point de contact.

De manière avantageuse, la zone de contact est recouverte d'un matériau réduisant l'usure par abrasion de la céramique piézoélectrique, par exemple une résine époxy.

L'actionneur selon l'invention offre un rapport volume du stator/volume du rotor réduit par rapport aux actionneurs de l'état de la technique, il présente donc une plus grande compacité.

La présente invention a pour objet un actionneur pour moteur ultrasonique comportant un élément en matériau piézoélectrique sous forme de plaque comportant au moins un bord de contact muni d'au moins une zone de contact destinée à entrer en contact avec un rotor du moteur ultrasonique, des électrodes destinées à solliciter le matériau piézoélectrique suivant un mode de flexion et suivant un mode longitudinal, dans lequel le bord de contact est concave et est formé par un premier arc de cercle présentant un premier rayon , ledit premier arc de cercle s'étendant angulairement suivant un angle déterminé de sorte que le mode de flexion et le mode longitudinal suivant lesquels le matériau piézoélectrique est sollicité sont à la même fréquence, et ladite au moins une zone de contact est concave et est portée par un deuxième arc de cercle présentant un deuxième rayon correspondant sensiblement au rayon de la surface du rotor destinée à entrer en contact avec l'actionneur.

De préférence, l'actionneur comporte deux zones de contact. Dans un exemple de réalisation, la ou les zones de contact sont en saillie par rapport au bord de contact, la ou les zones de contact étant en un matériau différent du matériau piézoélectrique, ledit matériau assurant une usure par abrasion réduite de l'élément en matériau piézoélectrique et du rotor.

Dans un autre exemple de réalisation, le premier rayon du premier arc de cercle formant le bord de contact et le deuxième rayon de l'arc de cercle formant la ou les zones de contact sont égaux de sorte que l'actionneur entre en contact avec le rotor par son bord de contact. Avantageusement, l'actionneur comporte une couche recouvrant le bord de contact, en un matériau différent du matériau piézoélectrique, ledit matériau offrant une usure par abrasion réduite de l'élément en matériau piézoélectrique et du rotor.

Par exemple, le matériau différent du matériau piézoélectrique assurant une usure par abrasion réduite de l'élément en matériau piézoélectrique et du rotor est une résine époxy.

L'actionneur peut comporter trois autres côtés, le bord opposé au bord de contact étant convexe et étant formé par un deuxième arc de cercle.

De préférence, les premier et deuxième arcs de cercle sont coaxiaux.

L'actionneur peut comporter quatre sommets et les électrodes destinées à solliciter un matériau piézoélectrique suivant un mode de flexion sont au nombre de quatre et sont situées chacune au niveau d'un sommet de l'actionneur et l'électrode destinée à solliciter le matériau piézoélectrique suivant un mode longitudinal forme sensiblement une croix entre les quatre électrodes destinées à solliciter le matériau piézoélectrique suivant un mode de flexion.

De préférence, la différence entre le deuxième rayon et le premier rayon est comprise entre 0,5 mm et 1 mm.

La présente invention a également pour objet moteur ultrasonique comportant au moins un actionneur suivant l'invention formant stator et un rotor dont la surface extérieure est en contact avec ladite zone de contact dudit actionneur. Le moteur ultrasonique peut présenter un degré de liberté et comporter un seul actionneur.

Dans un autre exemple de réalisation, le moteur ultrasonique présente au moins deux degrés de liberté, au moins deux actionneurs et un rotor présentant une surface extérieure au moins en partie sphérique.

Le moteur ultrasonique peut comporter un support pour chacun des actionneurs et des moyens de connexion des électrodes à une source de tension alternative, chaque support maintenant l'actionneur au niveau de ses bords autres que le bord de contact.

Dans un exemple de réalisation, le logement comporte des bossages en contact avec les bords de l'actionneur autres que le bord de contact au niveau des zones des bords de l'actionneur qui présentent un déplacement nul en flexion.

De manière avantageuse, le rotor est en aluminium.

## BRÈVE DESCRIPTION DES DESSINS

La présente invention sera mieux comprise à l'aide de la description qui va suivre et des dessins en annexes sur lesquels :

- la figure 1 est une représentation schématique d'un exemple de réalisation d'un actionneur selon la présente invention,
- la figure 2 est une vue de dessus d'un autre exemple de réalisation d'un actionneur,
- la figure 3 est une représentation schématique d'un moteur ultrasonique à un degré de liberté comportant un actionneur selon la présente invention,
- la figure 4A est une vue éclatée d'un moteur ultrasonique à deux degrés de liberté comportant deux actionneurs selon la présente invention,
- les figures 4B à 4D sont des vues de détail du moteur de la figure 4A,
- la figure 5A est une vue de détail d'un moteur ultrasonique selon la présente invention, sur laquelle on peut voir un actionneur disposé dans son support représenté en partie,
- la figure 5B est une vue en perspective du moteur de la figure 5A, le support étant entièrement représenté,
- la figure 5C est une variante de réalisation du support et de l'actionneur,
- les figures 6A à 6D sont des vues de côtés d'exemples de réalisation d'actionneur selon la présente invention, sur lesquelles on peut voir les électrodes de stimulation selon le mode longitudinal et le mode de flexion,
- les figures 7A et 7B sont des représentations schématiques d'un actionneur selon la présente invention sollicité suivant un mode longitudinal et un mode de flexion respectivement, lesdites représentations étant obtenues par éléments finis,
- la figure 8 est une représentation graphique permettant de déterminer l'angle des actionneurs selon la présente invention.

## EXPOSÉ DÉTAILLÉ DE MODES DE RÉALISATION PARTICULIERS

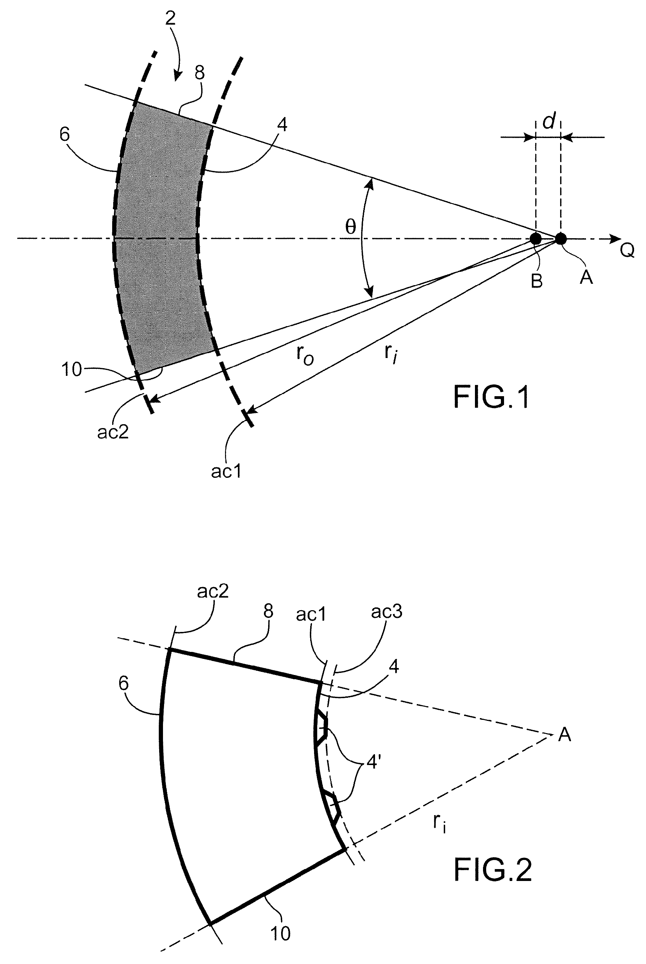

Sur la figure 1, on peut voir une représentation schématique d'un actionneur selon un exemple de réalisation désigné par la référence 2.

L'actionneur 2 a la forme d'une plaque délimitée par quatre cotés 4, 6, 8 et 10. Le coté 4 forme un bord de contact destiné à entrer en contact avec le rotor. Les cotés 6, 8 et 10 forment des bords de maintien dudit actionneur dans un support qui sera décrit par la suite.

Le bord de contact 4 présente une forme incurvée concave correspondant au contour extérieur du rotor, et formant un berceau pour le rotor.

Le rotor peut être par exemple une sphère ou un cylindre de révolution.

Comme cela est représenté sur la figure 1, le bord de contact 4 est formé par un arc de cercle ac1 de rayon ri centré sur le point A et s'étendant angulairement sur un angle $\theta$.

Dans l'exemple représenté, le bord 6 opposé au bord de contact 4 est également formé par un arc de cercle ac2 de rayon ro et centré sur un point B. L'arc de cercle ac2 s'étend également angulairement sur un angle $\theta$. Le bord 6 sera désigné par la suite par "bord de maintien".

Les points A et B sont portés par la bissectrice de l'angle $\theta$. d est la distance entre les centres A et B, i.e. le désaxage ente les centre des arcs de cercle ac1 et ac2.

Les deux bords latéraux 8 et 10 reliant le bord de contact 4 et le bord de maintien 8 sont formés par deux segments.

Dans cet exemple de réalisation, le bord de contact 4 est destiné à venir en contact avec le rotor, le rayon ri du bord de contact 4 est alors choisi en fonction du rayon du rotor de sorte que le contact entre le rotor et le bord de contact 4 soit le plus grand possible.

Un actionneur dans lequel les points A et B seraient confondus ne sort pas du cadre de la présente invention.

Un actionneur dans lequel le bord de maintien 6 serait un bord droit ou toute autre forme, ne sort pas du cadre de la présente invention. En outre, la forme droite des bords latéraux n'est pas limitative et ils pourraient également être de forme incurvée concave ou convexe. On pourrait envisager que les bords 6, 8 et 10 soient confondus.

L'actionneur est réalisé en un matériau piézoélectrique par exemple en Titano-Zirconate de Plomb (PZT), en Oxyde de Zinc (ZnO) ou encore en Titanate de baryum (BaTiO3).

De manière avantageuse, le bord de contact 4 est recouvert d'une couche 9 de matériau plus ductile que la céramique piézoélectrique, évitant le contact direct entre la céramique piézoélectrique et le rotor ce qui réduit à la fois l'usure de l'actionneur et l'usure du rotor. Ce matériau est par exemple formé par une résine époxy. De préférence, le rotor est alors en aluminium, en effet le couple de friction entre l'aluminium et la résine époxy présente de bonnes performances. La couche 9 a pour fonction de réduire l'usure par abrasion et d'absorber une partie de la contrainte.

Sur la figure 2A, on peut voir un autre exemple d'actionneur dans lequel l'actionneur entre en contact avec le rotor, non pas par son bord de contact 4 directement, mais pas des zones en saillie 4' du bord de contact 4, deux zones dans l'exemple représenté, ces zones 4' étant désignées "zones de contact". Les zones de contact 4' sont portées par un arc de cercle ac3 dont le rayon correspond alors sensiblement à celui du rotor. Les zones de contact 4' en saillie sont avantageusement réalisées dans un matériau similaire à celui de la couche 9 décrite ci-dessus, par exemple en époxy. Les zones de contact 4' réduisent l'usure par abrasion et absorbent une partie de la contrainte. En modifiant leur taille, on optimise la taille du contact entre l'actionneur et le rotor.

Les zones de contact ont par exemple une hauteur comprise entre 0,5 mm et 1 mm, hauteur qui correspond à la différence entre le rayon de l'arc de cercle ac3 portant les zones de contact et ri.

Les zones de contact 4' s'étendent par exemple sur une portion angulaire comprise entre 2° et la totalité de l'angle $\theta$, i.e. tout le bord de contact 4 de l'actionneur (figure 1).

L'une des faces de l'actionneur 2 porte des électrodes.

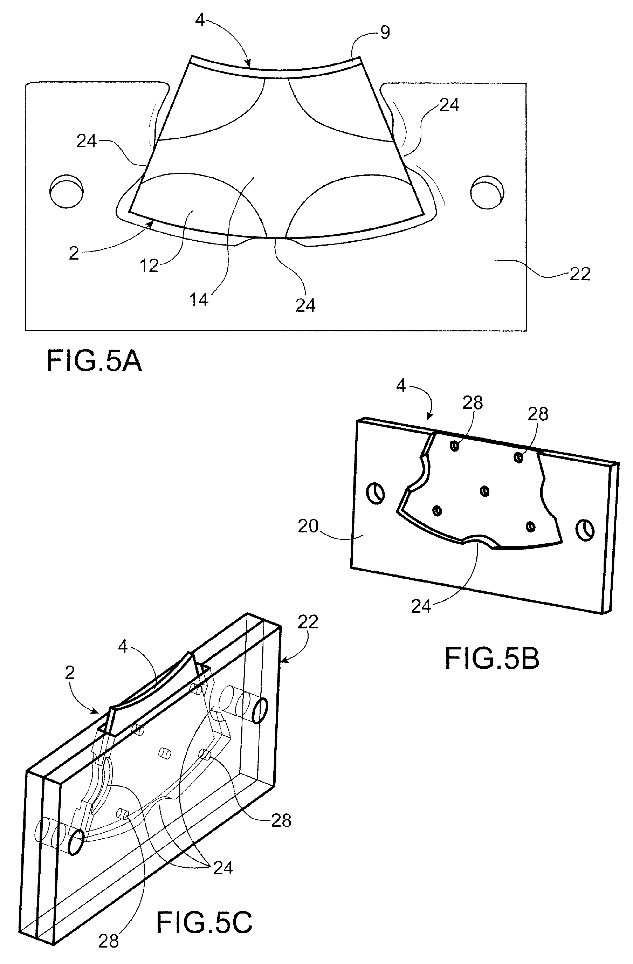

Sur les figures 5A et 5B, on peut voir un exemple d'actionneur monté dans un support et sur lequel les électrodes sont représentées. Dans l'exemple représenté, l'actionneur comporte quatre électrodes 12 destinées à solliciter l'actionneur suivant un mode de flexion et une électrode 14 destinée à solliciter l'actionneur suivant un mode longitudinal. Les électrodes 12 sont disposées sensiblement aux quatre sommets de l'actionneur et l'électrode 14 s'étend entre les électrodes 12 et présente sensiblement la forme d'une croix. Les électrodes 12 seront désignées « électrodes de flexion » et l'électrode 14 sera désignée « électrode longitudinale ». La face opposée de l'actionneur peut comporter une contre-électrode unique ou une contre-électrode pour chacune des électrodes de la première face. Lorsque l'actionneur comporte une seule contre-électrode, celle-ci est reliée à la masse. En revanche, lorsqu'elle comporte plusieurs contre-électrodes, celle-ci peuvent être alimentée alternativement avec la haute tension ou mise à la masse.

Cela permet de « simuler » une alimentation symétrique (+/-V) à l'aide d'une alimentation asymétrique (+V/masse).

Le mode de flexion et le mode longitudinal sont orthogonaux. Afin d'obtenir un mouvement elliptique du bord de contact 4, l'actionneur est réalisé de telle sorte que les deux modes orthogonaux dans le même plan soient à la même fréquence. Pour cela, l'angle $\theta$ est choisi de façon à obtenir ces deux modes à la même fréquence.

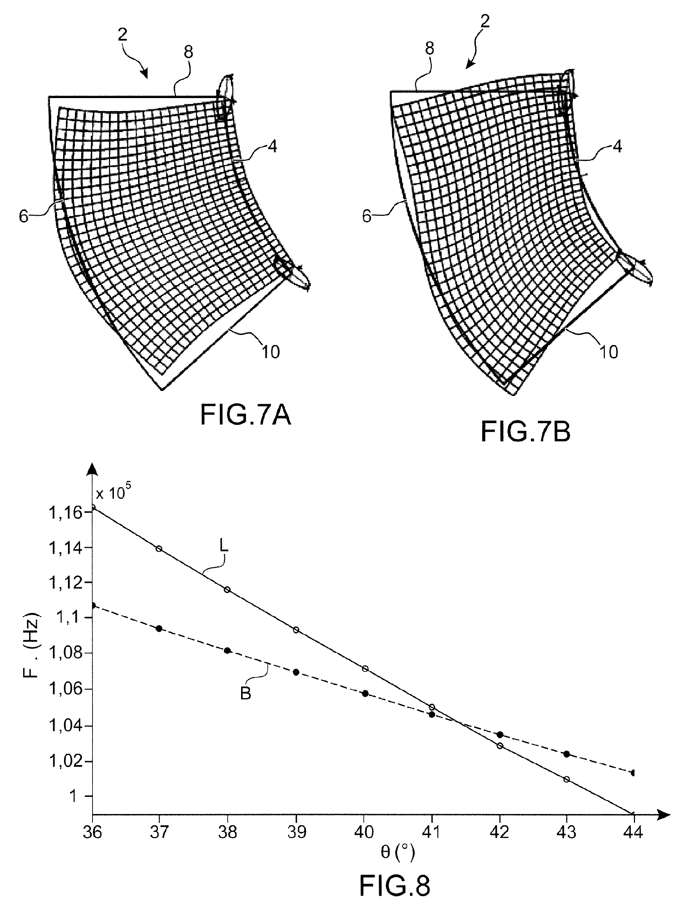

Sur la figure 8, on peut voir la variation de la fréquence du mode longitudinal désignée L en fonction de l'angle $\theta$ de l'actionneur, et la variation de la fréquence du mode de flexion désignée B en fonction de $\theta$. On constate que la variation des fréquences L et B sont linéaires et sont sécantes en un point correspondant à un angle donné, cet angle correspondant donc à l'angle d'un actionneur présentant deux modes orthogonaux à la même fréquence, c'est cette valeur qui fixe l'angle de l'actionneur.

A partir de la figure 8, on déduit que, pour un actionneur pour lequel les points A et B sont confondus, le rayon ri est égal à 15 mm, le rayon ro est égal à 25 mm, l'angle θ est égal à 41,4°.

Dans le tableau ci-dessous, sont regroupés plusieurs exemples de valeur d'angle θ d'un actionneur selon l'invention pour des couples de valeurs de ro (ligne) et d (colonne) et pour ri = 15 mm.

|  | 20 mm | 25 mm | 35 mm |
|---|---|---|---|
| **5 mm** |  | 24,89° |  |
| **0 mm** | 54,98° | 41,39° | 56,54° |
| **-5 mm** |  | 50,51° |  |

Les éléments piézoélectriques ont par exemple une épaisseur comprise entre 0,2 mm et 1 mm.

On peut également utiliser des éléments multicouches formés de plusieurs couches fines de matériau piézoélectrique séparées par des électrodes, ainsi la tension nécessaire au fonctionnement de l'actionneur est réduite. En effet lorsque l'épaisseur est plus fine, le champ électrique augmente ainsi que la déformation. De préférence, on utilise un élément multicouche pour bénéficier de l'effet de champ accru tout en conservant un actionneur suffisamment épais pour ne pas casser.

Le signe de d est considéré par rapport à la direction de l'axe Q, lorsque B est à droite de A sur la représentation de la figure 1, d est positif, et inversement lorsque B est à gauche de A comme cela est le cas sur la figure 1, d est négatif.

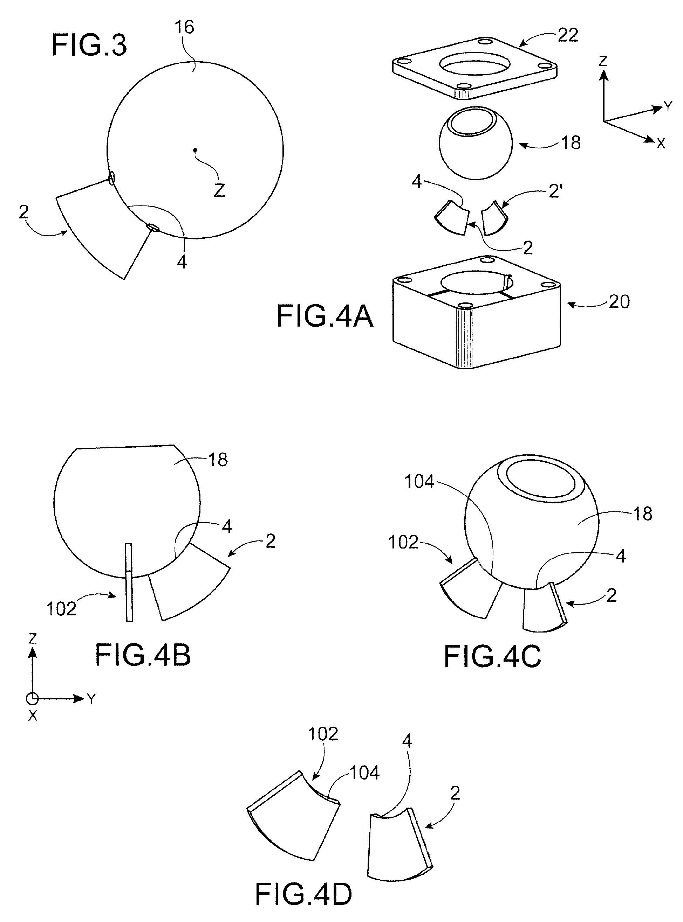

Sur la figure 3, on peut voir représentée de manière schématique un moteur ultrasonique M1 à un degré de liberté comportant un actionneur 2 selon la présente invention. Le moteur comporte un rotor cylindrique 16 d'axe Z. L'actionneur 2 est en contact par son bord de contact 4 avec le contour cylindrique du rotor 16 par au moins deux points de contact formés par les extrémités du bord de contact 4. L'application d'une tension alternative à l'actionneur de sorte à le solliciter suivant un mode longitudinal et un mode de flexion provoque la mise en rotation du rotor autour de l'axe Z.

Sur les figures 7A et 7B, on peut voir les déformées modales de l'actionneur selon la présente invention lorsqu'il lui est appliqué un mode longitudinal (figure 7A) et un mode de flexion (figure 7B). L'actionneur est stimulé suivant ces deux modes avec une différence de phase temporelle permettant d'obtenir un mouvement elliptique du bord de contact.

Les ellipses dessinées sur les figures 7A et 7B correspondent à un déphasage temporel de Π/2 dans la stimulation des deux modes.

En outre, la proximité des modes en fréquence permet de bénéficier de l'effet de résonance afin d'amplifier les mouvements au niveau du rotor.

Sur la figure 4A, on peut voir une vue en éclaté d'un exemple de réalisation d'un moteur ultrasonique M2 à deux degrés de liberté selon la présente invention. Le moteur ultrasonique M2 comporte un rotor 18 dont la surface destinée à venir en contact des actionneurs est de forme sphérique, un carter 20 dans lequel sont montés les actionneurs 2 et 102, et le rotor 18, et une plaque de fermeture 22 montée sur le carter 20. La plaque de fermeture 22 est munie d'une ouverture pour le passage d'un élément de transmission par exemple le manche d'un joystick solidaire du rotor dans une zone opposée à celle en contact avec les actionneurs 2, 102.

Comme on peut le voir sur les figures 4B à 4D, les deux actionneurs 2 et 102 sont montés perpendiculairement entre eux à l'intérieur du carter et dans deux plans perpendiculaires au plan contenant les axes X et Y autour desquels le rotor 18 est destiné à être entraîné en rotation. Le rotor 18 repose sur les bords de contact 4 et 104. Dans la représentation des figures 4A à 4C, les axes X et Y définissent un plan horizontal.

Pour réaliser un moteur ultrasonique à trois degrés de liberté, un troisième actionneur selon l'invention est disposé dans un plan perpendiculaire à celui des actionneurs 2, 102 avec son bord de contact en contact avec le rotor, celui-ci déplace le rotor autour d'un axe Z perpendiculaire aux axes X et Y.

Sur la figure 5A, comme mentionné précédemment, on peut voir représente un actionneur monté dans un support 22 dont une partie à été retirée.

Sur la figure 5B, le support en entier est représenté en transparence. Le support 22 est formé de deux plaques dans lesquelles est formé un logement dont la forme intérieure correspond sensiblement au contour extérieur de l'actionneur 2 formé par les bords latéraux 8 et 10 et par le bord de maintien 6. Le logement du support 22 comporte des moyens de maintien de l'actionneur évitant d'amortir les vibrations. Dans l'exemple représenté, ces moyens sont formés par trois points d'appui 24 situés de sorte à entrer en contact avec les bords 6, 8 et 10 de l'actionneur au niveau de l'électrode longitudinale, c'est-à-dire en des points de déplacement nul en flexion. Les trois points d'appui 24 sont formés par des bossages en saillie des parois du logement du support.

Le support est par exemple réalisé en bakélite.

Des moyens de connexion des électrodes à une source de tension alternative. Par exemple, une face latérale (non visible) du support peut être réalisée en une plaque de circuit imprimé dont la couche de cuivre est gravée afin de connecter les électrodes.

Sur la figure 5B, on peut voir l'une des parties du support réalisé dans des plaques de circuit imprimé, dont on peut voir la face latérale de connexion. Les perçages 28, visibles sur les figures 5B et 5C, permettent d'établir les contacts électriques avec les électrodes de l'actionneur 2. Ces contacts peuvent-être réalisés à l'aide de fils soudés ou de contacts mécaniques élastiques, tels que des ressorts.

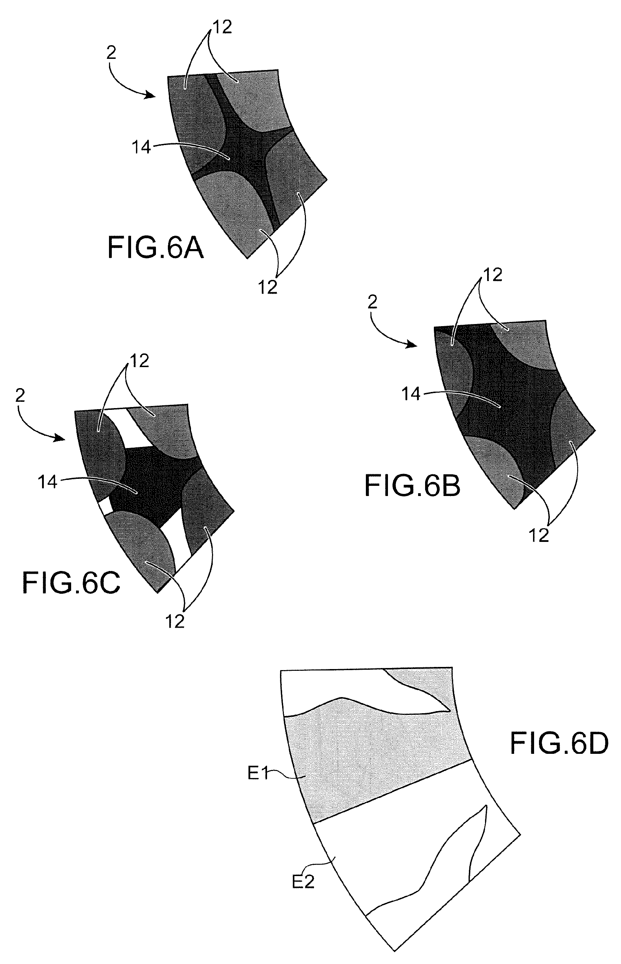

Sur les figures 6A à 6D, on peut voir différents exemples de disposition des électrodes de flexion 12 et de l'électrode longitudinale 14.

Sur les figures 6A et 6B, l'électrode longitudinale s'étend jusqu'aux bords 4, 6, 8 et 10, tandis que sur la figure 6C, elle ne s'étend que jusqu'au bord de contact 4. Ces formes d'électrodes sont particulièrement avantageuses car elles permettent d'éviter un couplage entre les deux modes de sollicitation des actionneurs et permettent d'optimiser la stimulation électrique et donc d'améliorer le rendement.

Sur la figure 6D, on peut voir un exemple d'actionneur comportant deux électrodes E1, E2 avec une stimulation combinée. Sur la première électrode E1 et sur la deuxième électrode E2 on applique les tensions VE1 et VE2 suivantes respectivement :

$$VE1 = VL1*sin(wt)+VB2*sin(wt+phi)$$

$$VE2 = VL1*sin(wt)-VB2*sin(wt+phi)$$

Avec VL1 l'excitation symétrique et VB2 l'excitation antisymétrique.

Les excitations sont alors combinées pour former une excitation unique. phi est le déphasage entre les deux modes.

Grace à l'actionneur selon la présente invention, on obtient un moteur ultrasonique robuste, puisque les contraintes ne sont plus localisées, de réalisation très simple puisque l'actionneur forme directement le support du rotor et présentant une grande compacité. En outre, il présente un rendement amélioré car la part utile de l'énergie électrique transmise à l'actionneur est augmentée grâce à la surface de contact augmentée.

Ce moteur ultrasonique selon la présente invention peut être utilisé dans de nombreux domaines, par exemple dans le déplacement d'instruments optiques telles que les caméras, les lentilles, les lasers, les micro-projecteurs, pour la stabilisation inertielle et le suivi d'objets. Il peut être également utilisé dans l'articulation de robots, en particulier de robots compacts du fait de sa taille réduite, dans les micromanipulateurs, dans les interfaces à retour d'effort type joystick....

**Revendications**

1.  Moteur ultrasonique comportant au moins un actionneur formant stator et un rotor (16, 18), ledit actionneur comportant un élément sous forme de plaque en matériau piézoélectrique comportant au moins un bord de contact (4) muni d'au moins une zone de contact (4') en contact avec un rotor du moteur ultrasonique, des électrodes (12, 14) destinées à solliciter le matériau piézoélectrique suivant un mode de flexion et suivant un mode longitudinal, dans lequel le bord de contact est concave et est formé par un premier arc de cercle (ac1) présentant un premier rayon (ri), ledit premier arc de cercle (ac1) s'étendant angulairement suivant un angle ($\theta$) déterminé de sorte que le mode de flexion et le mode longitudinal suivant lesquels le matériau piézoélectrique est sollicité sont à la même fréquence, et ladite au moins une zone de contact (4') est concave et est portée par un deuxième arc de cercle présentant un deuxième rayon (ac3) correspondant sensiblement au rayon de la surface du rotor.

2.  Moteur ultrasonique selon la revendication 1, comportant deux zones de contact (4').

3.  Moteur ultrasonique selon la revendication 1 ou 2, dans lequel la ou les zones de contact (4') sont en saillie par rapport au bord de contact, la ou les zones de contact étant en un matériau différent du matériau piézoélectrique, ledit matériau assurant une usure par abrasion réduite de l'élément en matériau piézoélectrique et du rotor.

4.  Moteur ultrasonique selon la revendication 1, dans lequel le premier rayon du premier arc de cercle (ac1) formant le bord de contact (4) et le deuxième rayon de l'arc de cercle (ac3) formant la ou les zones de contact (4') sont égaux de sorte que l'actionneur entre en contact avec le rotor par son bord de contact (4).

5.  Moteur ultrasonique selon la revendication 4, comportant une couche (9) recouvrant le bord de contact (4), en un matériau différent du matériau piézoélectrique, ledit matériau offrant une usure par abrasion réduite de l'élément en matériau piézoélectrique et du rotor.

6.  Moteur ultrasonique selon la revendication 3 ou 5, dans lequel le matériau différent du matériau piézoélectrique assurant une usure par abrasion réduite de l'élément en matériau piézoélectrique et du rotor est une résine époxy.

7.  Moteur ultrasonique suivant l'une des revendications 1 à 6, comportant trois autres côtés (6, 8 ,10), le bord (6) opposé au bord de contact étant convexe et étant formé par un deuxième arc de cercle (ac2).

8.  Moteur ultrasonique suivant la revendication 7, dans lequel les premier et deuxième arcs (ac1, ac2) de cercle sont coaxiaux.

9.  Moteur ultrasonique selon les revendications 1 à 8, dans lequel l'actionneur comporte quatre sommets et dans lequel les électrodes (12) destinées à solliciter un matériau piézoélectrique suivant un mode de flexion sont au nombre de quatre et sont situées chacune au niveau d'un sommet de l'actionneur et l'électrode (14) destinée à solliciter le matériau piézoélectrique suivant un mode longitudinal forme sensiblement une croix entre les quatre électrodes (12) destinées à solliciter le matériau piézoélectrique suivant un mode de flexion.

10. Moteur ultrasonique selon l'une des revendications 1 à 3, dans lequel la différence entre le deuxième rayon et le premier rayon (ri) est comprise entre 0,5 mm et 1 mm.

11. Moteur ultrasonique suivant l'une des revendications 1 à 10, dans lequel le rotor (16, 18), est en aluminium.

12. Moteur ultrasonique suivant l'une des revendications 1 à 11, présentant un degré de liberté et comportant un seul actionneur (2).

13. Moteur ultrasonique suivant l'une des revendications 1 à 11, présentant au moins deux degrés de liberté, au moins deux actionneurs (2, 102) et un rotor (18) présentant une surface extérieure au moins en partie sphérique.

14. Moteur ultrasonique selon l'une des revendications 1 à 13, comportant un support (22) pour chacun des actionneurs (2, 102) et des moyens de connexion des électrodes à une source de tension alternative, chaque support (20) maintenant l'actionneur (2, 102) au niveau de ses bords (6, 8, 10) autres que le bord de contact (4).

15. Moteur ultrasonique selon la revendication 14, dans lequel le support comporte des bossages (24) en contact avec les bords (6, 8, 10) de l'actionneur autres que le bord de contact (4) au niveau des zones des bords (6, 8, 10) de l'actionneur qui présentent un déplacement nul en flexion.

**Patentansprüche**

1. Ultraschallmotor, umfassend wenigstens ein Betätigungselement, das einen Stator bildet, sowie einen Rotor (16, 18), wobei das Betätigungselement ein plattenförmiges Element aus einem piezoelektrischen Material umfasst, umfassend wenigstens einen Kontaktrand (4), der mit wenigstens einer Kontaktzone (4') in Kontakt mit einem Rotor des Ultraschallmotors ausgestattet ist, ferner Elektroden (12, 14), die dazu ausgelegt sind, das piezoelektrische Material gemäß einer Biegemode und gemäß einer Longitudinalmode zu erregen, wobei der Kontaktrand konkav ist und durch einen ersten Kreisbogen (ac1) gebildet ist, der einen ersten Radius (ri) aufweist, wobei der erste Kreisbogen (ac1) sich angular über einen Winkel ($\theta$) erstreckt, der derart bestimmt ist, dass die Biegemode und die Longitudinalmode, gemäß denen das piezoelektrische Material erregt wird, bei der gleichen Frequenz sind, und wobei die wenigstens eine Kontaktzone (4') konkav ist und von einem zweiten Kreisbogen getragen wird, der einen zweiten Radius (ac3) aufweist, der im Wesentlichen dem Radius der Oberfläche des Rotors entspricht.

2. Ultraschallmotor nach Anspruch 1, umfassend zwei Kontaktzonen (4').

3. Ultraschallmotor nach Anspruch 1 oder 2, wobei die Kontaktzone(n) (4') bezüglich des Kontaktrands vorstehen, wobei die Kontaktzone(n) aus einem von dem piezoelektrischen Material verschiedenen Material sind, wobei das Material einen verringerten Verschleiß des Elements aus piezoelektrischem Material und des Rotors durch Abrasion gewährleistet.

4. Ultraschallmotor nach Anspruch 1, wobei der erste Radius des ersten Kreisbogens (ac1), der den Kontaktrand (4) bildet, und der zweite Radius des Kreisbogens (ac3), der die Kontaktzone(n) (4') bildet, gleich sind, derart, dass das Betätigungselement durch seinen Kontaktrand (4) in Kontakt mit dem Rotor gelangt.

5. Ultraschallmotor nach Anspruch 4, umfassend eine Schicht (9), die den Kontaktrand (4) bedeckt, aus einem vom dem piezoelektrischen Material verschiedenen Material, wobei das Material einen verringerten Verschleiß des Elements aus piezoelektrischem Material und des Rotors durch Abrasion bietet.

6. Ultraschallmotor nach Anspruch 3 oder 5, bei dem das von dem piezoelektrischen Material verschiedene Material, das einen verringerten Verschleiß des Elements aus piezoelektrischem Material und des Rotors durch Abrasion gewährleistet, ein Epoxidharz ist.

7. Ultraschallmotor nach einem der Ansprüche 1 bis 6, umfassend drei weitere Seiten (6, 8, 10), wobei der Rand (6) gegenüber dem Kontaktrand konvex ist und durch einen zweiten Kreisbogen (ac2) gebildet ist.

8. Ultraschallmotor nach Anspruch 7, bei dem der erste und der zweite Kreisbogen (ac1, ac2) koaxial sind.

9. Ultraschallmotor nach den Ansprüchen 1 bis 8, wobei das Betätigungselement vier Spitzen umfasst, und wobei die Elektroden (12), die dazu ausgelegt sind, ein piezoelektrisches Material gemäß einer Biegemode zu erregen, vierfach vorhanden sind und jeweils im Bereich einer Spitze des Betätigungselements angeordnet sind, und wobei die Elektrode (14), die dazu ausgelegt ist, das piezoelektrische Material gemäß einer Longitudinalmode zu erregen, im Wesentlichen ein Kreuz zwischen den vier Elektroden (12) bildet, die dazu ausgelegt sind, das piezoelektrische Material gemäß einer Biegemode zu erregen.

10. Ultraschallmotor nach einem der Ansprüche 1 bis 3, wobei die Differenz zwischen dem zweiten Radius und dem ersten Radius (ri) zwischen 0,5 mm und 1 mm enthalten ist.

11. Ultraschallmotor nach einem der Ansprüche 1 bis 10, wobei der Rotor (16, 18) aus Aluminium ist.

12. Ultraschallmotor nach einem der Ansprüche 1 bis 11, der einen Freiheitsgrad aufweist und ein einziges Betätigungselement (2) umfasst.

13. Ultraschallmotor nach einem der Ansprüche 1 bis 11, der wenigstens zwei Freiheitsgrade aufweist, wenigstens zwei Betätigungselemente (2, 102) sowie einen Rotor (18), der eine wenigstens teilweise kugelförmige Außenoberfläche aufweist.

14. Ultraschallmotor nach einem der Ansprüche 1 bis 13, umfassend einen Träger (22) für jedes der Betätigungselemente (2, 102) und Mittel zum Anschließen der Elektroden an eine Wechselspannungsquelle, wobei jeder Träger (20) das Betätigungselement (2, 102) im Bereich seiner Ränder (6, 8, 10) außer dem Kontaktrand (4) hält.

15. Ultraschallmotor nach Anspruch 14, wobei der Träger Ausbauchungen (24) in Kontakt mit den Rändern (6, 8, 10) des Betätigungselements außer dem Kontaktrand (4) im Bereich der Randzonen (6, 8, 10) des Betätigungselements umfasst, die bei Biegung eine Null-Verlagerung aufweisen.

**Claims**

1. Ultrasonic motor comprising at least one actuator forming a stator and a rotor (16,18), said actuator comprising an plate-shaped element of piezoelectric material comprising at least one contact edge (4) provided with at least one contact area (4') contacting a rotor of the ultrasonic motor, electrodes (12, 14) configured to bias the piezoelectric material in a bending mode and in a longitudinal mode, wherein the contact edge is concave and is formed by a first arc of circle (ac1) having a first radius (ri), said first arc of circle (ac1) extending angularly at a determined angle (θ) such that the bending mode and the longitudinal mode in which the piezoelectric material is biased are at the same frequency, and said at least one contact area (4') is concave and is carried by a second arc of circle having a second radius (ac3) substantially corresponding to the radius of the surface of the rotor.

2. Ultrasonic motor according to claim 1, comprising two contact areas (4').

3. Ultrasonic motor according to claim 1 or 2, wherein the contact area(s) (4') is (are) projecting from the contact edge, the contact area(s) being of a material different from the piezoelectric material, said material ensuring a reduced abrasive wear of the element of piezoelectric material and the rotor.

4. Ultrasonic motor according to claim 1, wherein the first radius of the first arc of circle (ac1) forming the contact edge (4) and the second radius of the arc of circle (ac3) forming the contact area(s) (4') are equal such that the actuator contacts the rotor through its contact edge (4).

5. Ultrasonic motor according to claim 4, comprising a layer (9) covering the contact edge (4), of a material different from the piezoelectric material, said material providing a reduced abrasive wear of the element of piezoelectric material and of the rotor.

6. Ultrasonic motor according to claim 3 or 5, wherein the material different from the piezoelectric material providing a reduced abrasive wear of the element of piezoelectric material and of the rotor is an epoxy resin.

7. Ultrasonic motor according to claims 1 to 6, comprising three other sides (6, 8, 10), the opposite edge (6) to the contact edge being convex and being formed by a second arc of circle (ac2).

8. Ultrasonic motor according to claim 7, wherein the first and second arcs (ac1, ac2) of circle are coaxial.

9. Ultrasonic motor according to claims 1 to 8, wherein the actuator comprises four vertices and wherein the number of electrodes (12) configured to bias a piezoelectric material in a bending mode is four and they are each located at a vertex of the actuator and the electrode (14) configured to bias the piezoelectric material in a longitudinal mode substantially forms a cross between the four electrodes (12) configured to bias the piezoelectric material in a bending mode.

10. Ultrasonic motor according to one of claims 1 to 3, wherein the difference between the second radius and the first radius (ri) is between 0.5 mm and 1 mm.

11. Ultrasonic motor according to one of claims 1 to 10, wherein the rotor (16, 18) is of aluminium.

12. Ultrasonic motor according to one of claims 1 to 11, having one degree of freedom and comprising a single actuator (2).

13. Ultrasonic motor according to one of claims 1 to 11, having at least two degrees of freedom, at least two actuators (2, 102) and one rotor (18) having an external surface being at least partly spherical.

14. Ultrasonic motor according to one of claims 1 to 13, comprising a support (22) for each of the actuators (2, 102) and means for connecting the electrodes to an A. C. voltage source, each support (20) holding the actuator (2, 102) at its edges (6, 8, 10) other than the contact edge (4).

15. Ultrasonic motor according to claim 14, wherein the housing comprises bosses (24) in contact with the edges (6, 8, 10) of the actuator other than the contact edge (4) at the areas of the edges (6, 8, 10) of the actuator which have a null bending displacement.

FIG.1

FIG.2

# FIG.3

# FIG.4A

# FIG.4B

# FIG.4C

# FIG.4D

FIG.5A

FIG.5B

FIG.5C

FIG.6A

FIG.6B

FIG.6C

FIG.6D

FIG.7A

FIG.7B

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **M. ZHANG ; W. GUO ; L. SUN.** A multi-degree-of-freedom ultrasonic motor using in-plane déformation of planar piezoelectric Elements. *Sensors and Actuators A: Physical,* Novembre 2008, vol. 148 (1), 193-200
- **LI et al.** Design and optimization of a novel annular sector curvilinear ultrasonic motor. *ULTRASONICS SYMPOSIUM,* 2008, 1831-1834
- Particle swarm optimization combined with finite element method for design of ultrasonic motors. *SENSORS AND ACTUATORS A,* vol. 148 (1), 285-289
- **SHENG-CHIH SHEN ; JUIN-CHERNG HUANG.** Design and Fabrication of a High-Power Eyeball-Like Microactuator Using a Symmetric Piezoelectric Pusher Element. *Microelectromechanical Systems, Journal,* 2010, vol. 19 (6), 1470-1476